# FASCICULE DE BREVET EUROPEEN

(11) **EP 1 111 783 B1**
(45) Date de publication et mention de la délivrance du brevet: **01.10.2008**
(21) Numéro de dépôt: 00403608.3
(22) Date de dépôt: 20.12.2000
(51) Int. Cl.: H03K 3/3562

(54) **Bascule de type D maître-esclave sécurisée**
Gesicherte Typ D Master-Slave Kippschaltung
Protected D-type master-slave flip-flop

(30) Priorité: 21.12.1999 FR 9916180
(43) Date de publication de la demande: 27.06.2001
(73) Titulaire: STMicroelectronics S.A., 92120 Montrouge (FR)
(72) Inventeur: Pomet, Alain, 94230 Cachan (FR)
(74) Mandataire: Bentz, Jean-Paul

(56) Documents cités:
- EP-A- 0 219 846
- EP-A- 0 624 950
- US-A- 4 873 456

## Description

La présente invention concerne une bascule de type D maître-esclave de structure sécurisée.

Elle concerne les applications dans lesquelles l'accès à des services ou des données est sévèrement contrôlé, et qui utilisent des circuits électroniques mettant en oeuvre des moyens matériels et/ou logiciels de sécurité. De tels circuits électroniques sont notamment utilisés dans des cartes à puce ou des microcircuits, pour certaines applications comme les applications d'accès à certaines banques de données, des applications bancaires ou autres. Pour ces applications, ces circuits électroniques qui ont une architecture formée autour d'un microprocesseur et de mémoires, sont par exemple amenés à traiter des données secrètes ou confidentielles et à utiliser des algorithmes de cryptographie pour chiffrer des messages à transmettre à l'extérieur, déchiffrer des messages reçus, ou calculer des signatures.

Or il est apparu qu'il était possible de mener des attaques externes basées sur une analyse différentielle de consommation en courant du circuit lors de l'exécution de certaines instructions. Notamment, on a pu montrer qu'il était possible de déterminer ainsi tout ou partie d'une clé secrète utilisée dans un algorithme de cryptographie exécuté par le microprocesseur. Ces attaques externes, appelées attaques DPA, acronyme anglo-saxon pour *Differential Power Analysis*, sont basées sur le fait que la consommation en courant du microprocesseur exécutant des instructions varie selon la donnée manipulée. Par exemple, lorsqu'une instruction exécutée par le microprocesseur nécessite une manipulation bit par bit, on a, à cet instant d'exécution, deux profils de consommation différents selon que le bit manipulé vaut "1" ou "0".

Ainsi l'attaque DPA exploite la différence du profil de consommation en courant dans le circuit électronique pendant l'exécution d'une instruction suivant la valeur du ou des bits manipulés. D'une façon très simplifiée, cette attaque utilise une approche statistique, pour vérifier des hypothèses sur la valeur des bits d'une donnée confidentielle, en faisant dérouler un grand nombre de fois un même scénario dans le circuit électronique, avec des valeurs différentes d'entrées de ce scénario, et en analysant tous les profils de consommation obtenus.

La présente invention a pour objet de rendre plus difficile de telles attaques DPA sur certaines instructions, c'est à dire de rendre impossible au premier ordre la différentiation entre la manipulation d'un "1" et la manipulation d'un "0" par ces instructions par l'analyse différentielle des profils de consommation.

Toutes les données manipulées dans un circuit électronique transitent entre des mémoires et le microprocesseur par des registres. D'autres registres sont utilisés par le microprocesseur pour stocker des données lors de l'exécution de certains programmes.

Certains de ces registres sont plus particulièrement amenés à transmettre des données sensibles, telle qu'une clé secrète d'un algorithme de cryptographie.

Ces registres sont habituellement basés sur des bascules D maître-esclave, communément appelées flip-flop. Dans ce type de bascule, si on présente en entrée une nouvelle donnée, qui correspond à la donnée déjà stockée dans cette bascule, il n'y a aucune commutation dans la bascule. Or la commutation dans la bascule entraîne une consommation de courant déterminée.

Ainsi, selon que la donnée change ou ne change pas dans la bascule, on a deux profils (ou signature) de consommation distincts, ce qui peut permettre une attaque DPA par analyse différentielle lors de l'utilisation de ces registres.

Un objet de l'invention est de proposer une bascule D maître-esclave sécurisée, en sorte que le profil de consommation en courant de cette bascule soit indépendant des données manipulées dans cette bascule.

L'idée à la base de l'invention est de prévoir des moyens dans la bascule elle-même pour qu'il y ait toujours une commutation, quel que soit l'état courant dans la bascule et l'état de la nouvelle donnée présentée en entrée.

L'invention concerne donc une bascule D maître-esclave, comprenant un étage maître suivi d'un étage esclave, les deux étages étant de structure identique comprenant une première porte de transfert pour transmettre sur un noeud interne une donnée d'entrée, une boucle de mémorisation à inverseurs connectée au dit noeud interne pour fournir une donnée en sortie de l'étage et comprenant une deuxième porte de transfert pour transmettre sur le dit noeud interne la donnée complémentaire de la donnée de sortie, caractérisée en ce que la bascule comprend en outre un circuit de masquage de consommation comprenant en parallèle sur chacun des étages maître et esclave, un étage témoin de structure similaire dont la boucle de mémorisation est déconnectée de la sortie de l'étage maître ou esclave associé, la deuxième porte de transfert de cette boucle de mémorisation de l'étage témoin étant connectée entre la sortie de l'étage maître ou esclave associé et le noeud interne de l'étage témoin.

L'invention concerne aussi tout circuit intégré comprenant au moins une bascule sécurisée de ce type en particulier pour les registres amenés à traiter des données confidentielles ou secrètes.

D'autres caractéristiques et avantages de l'invention sont détaillés dans la description suivante de différents modes de réalisation, présentés à titre indicatif et non limitatif, et en référence aux dessins annexés dans lesquels :
- la figure 1 représente une bascule D maître-esclave selon l'état de l'art ;
- la figure 2 représente une bascule D maître-esclave selon l'invention;
- la figure 3 montre l'évolution des différents noeuds internes dans une telle bascule, en fonction des données d'entrée et
- les figures 4a et 4b représentent le schéma équivalent de la bascule maître-esclave selon l'invention sur un niveau haut, respectivement sur un niveau bas du signal d'horloge H de séquencement de la bascule.

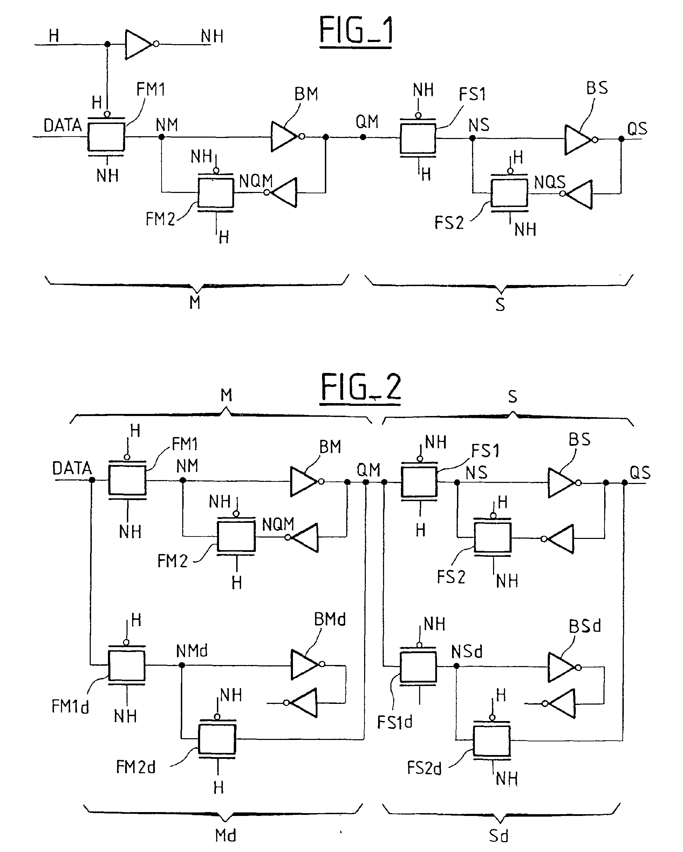

La figure 1 représente la structure habituelle d'une bascule D maître-esclave. Elle comprend un étage maître M suivi d'un étage esclave S. Ces deux étages sont de structures identiques, correspondant à une bascule de type D, et ils sont commandés en opposition de phase.

Si on prend l'étage maître, cette structure comprend une première porte de transfert FM1 et une deuxième porte de transfert FM2 chacune connectée en sortie au même noeud interne NM d'entrée d'une boucle de mémorisation BM à inverseurs. Ces deux portes de transfert FM1, FM2 sont commandées en opposition de phase par un signal d'horloge H de séquencement de la bascule. La première porte de transfert FM1 permet de transmettre sur ce noeud NM la donnée DATA appliquée en entrée de l'étage, dans une phase. La deuxième porte de transfert FM2 permet d'imposer sur ce noeud NM la donnée complémentaire NQM de la sortie QM de l'étage, dans l'autre phase.

Chaque porte de transfert comprend typiquement deux transistors de types opposés, dans l'exemple un transistor MOS de type P et un transistor MOS de type N. Les transistors d'une porte de transfert sont commandés à partir du signal d'horloge H de séquencement de la bascule, afin qu'ils soient passants en même temps et bloqués en même temps.

Dans l'exemple représenté, la première porte de transfert FM1 est équivalente à un circuit ouvert sur le niveau haut du signal d'horloge H et équivalente à un court-circuit sur le niveau bas du signal d'horloge, tandis que la deuxième porte de transfert FM2 est équivalente à un court-circuit sur le niveau haut du signal d'horloge H et équivalente à un circuit ouvert sur le niveau bas du signal d'horloge.

La boucle de mémorisation BM comprend dans l'exemple un premier inverseur connecté entre le noeud interne NM et la sortie QM de l'étage et un deuxième inverseur connecté entre cette sortie QM et la deuxième porte de transfert FM2.

Ainsi, on retrouve en sortie du deuxième inverseur, la sortie complémentaire NQM appliquée en entrée de la deuxième porte de transfert FM2.

L'étage esclave a une structure identique. Ainsi aux références FM1, FM2, NM, BM, QM et NQM dans l'étage maître, correspondent les références FS1, FS2, NS, BS, QS et NQS dans l'étage esclave. Les portes de transfert de l'étage esclave sont commandées en opposition de phase par rapport à celles de l'étage maître. Ainsi, dans l'exemple, la première porte de transfert FM1 de l'étage maître et la deuxième porte de transfert FS2 de l'étage esclave sont passantes (équivalentes à des courts-circuits) sur le niveau bas du signal d'horloge H et bloquées (équivalentes à des circuits ouverts) sur le niveau haut du signal d'horloge H ; la deuxième porte de transfert FM2 de l'étage maître et la première porte de transfert FS1 de l'étage esclave sont passantes (équivalentes à des courts-circuits) sur le niveau haut et bloquées (équivalentes à des circuits ouverts) sur le niveau bas du signal d'horloge H.

Avec une telle bascule D maître-esclave selon l'état de la technique, si une nouvelle donnée se présente en entrée de l'étage maître, identique à la donnée précédente, aucune commutation n'aura lieu, ni dans l'étage maître, ni dans l'étage esclave. En effet, si le noeud NM est déjà au niveau de la nouvelle donnée en entrée, il n'y aura aucun changement dans aucune des deux boucles de mémorisation, maître et esclave et donc aucune commutation dans la bascule D maître-esclave. Alors que si on applique en entrée de la bascule maître-esclave une donnée de niveau différent, sur le premier front descendant suivant, on va avoir une commutation dans la boucle de mémorisation de l'étage maître, puis, sur le front montant suivant, on va avoir une commutation dans la boucle de mémorisation de l'étage esclave.

Ainsi, avec une bascule D maître-esclave selon l'état de la technique, on peut avoir à un moment donné, en fonction de la donnée manipulée en entrée, soit aucune commutation dans la bascule, soit une commutation dans la boucle de mémorisation de l'un ou l'autre des étages maître et esclave. Cette caractéristique de fonctionnement de la bascule D maître-esclave permet une analyse différentielle sur la signature en courant d'un circuit lorsqu'il utilise des registres basés sur de telles bascules, puisque selon la donnée manipulée, le profil de consommation en courant du circuit est différent.

La figure 2 représente une bascule D maître-esclave sécurisée selon l'invention, qui permet d'avoir un même profil de consommation dans tous les cas, en forçant la commutation dans la bascule sur chaque niveau haut et bas de l'horloge, indépendamment du flot de données d'entrée.

Cette bascule comprend deux étages maître M et esclave S comme précédemment, de structure identique. Pour la simplification de l'exposé, on a repris les mêmes références pour les éléments communs à la figure 1.

Selon l'invention, un circuit de masquage de consommation est prévu dans la bascule. Ce circuit de masquage comprend en parallèle sur chacun des étages maître et esclave, un étage témoin de structure similaire, dont la boucle de mémorisation est déconnectée de la sortie de l'étage maître ou esclave associé, la deuxième porte de transfert de cette boucle de mémorisation de l'étage témoin étant connectée entre la sortie de l'étage maître ou esclave associé et le noeud interne de l'étage témoin, dit "*dummy*" dans la littérature anglo-saxonne.

Pour la boucle de mémorisation de l'étage témoin, on prévoit de réaliser la même chaîne d'inverseurs que celle des boucles de mémorisation des étages maître et esclave, ou bien de réaliser la charge équivalente de cette chaîne d'inverseurs, vue du noeud interne de l'étage principal, pour obtenir un comportement identique sur le plan de la consommation que la boucle de mémorisation de l'étage principal auquel l'étage témoin est associé. Dans l'exemple, on remplace alors les deux inverseurs de la boucle par une capacité équivalente connectée entre le noeud interne et la masse, ce qui est suffisant au premier ordre. Une autre capacité (non représentée) peut être prévue entre la tension d'alimentation et le noeud interne, pour une meilleure approximation du comportement des deux inverseurs en commutation.

Dans l'exemple représenté sur la figure 2, l'étage témoin Md de l'étage maître comprend ainsi une première porte de transfert FM1d, pour transmettre la donnée d'entrée DATA sur un noeud interne NMd, une boucle de mémorisation BMd comprenant deux inverseurs en série de mêmes caractéristiques que celles de la boucle de mémorisation de l'étage maître et une deuxième porte de transfert FM2d pour transmettre la sortie QM de l'étage maître sur le noeud interne NMd de l'étage témoin.

L'étage témoin Sd de l'étage esclave S comprend, de manière similaire, une première porte de transfert FS1d, pour transmettre l'état de la sortie QM de l'étage maître sur un noeud interne NSd, une boucle de mémorisation BSd comprenant deux inverseurs en série de mêmes caractéristiques que celles de la boucle de mémorisation de l'étage esclave et une deuxième porte de transfert FS2d pour transmettre la sortie QS de l'étage esclave sur le noeud interne NSd de l'étage témoin. Les portes de transfert de chaque étage témoin sont commandées de la même façon que les portes de transfert correspondantes dans l'étage principal associé.

En prévoyant un tel étage témoin sur chacun des étages maître et esclave de la bascule, on force une commutation systématique dans la bascule sur chaque front d'horloge, quelque soit la donnée présentée en entrée. Cette commutation forcée dans la bascule consiste en pratique dans la commutation de deux des quatre boucles de mémorisation de l'étage, sur chaque front, ce qui entraîne la commutation de chacun des inverseurs de ces deux boucles. Ainsi, sur chacun des fronts montants et descendants du signal d'horloge de séquencement de la bascule, on obtient le même profil de consommation en courant (au premier ordre) indépendamment de la donnée d'entrée.

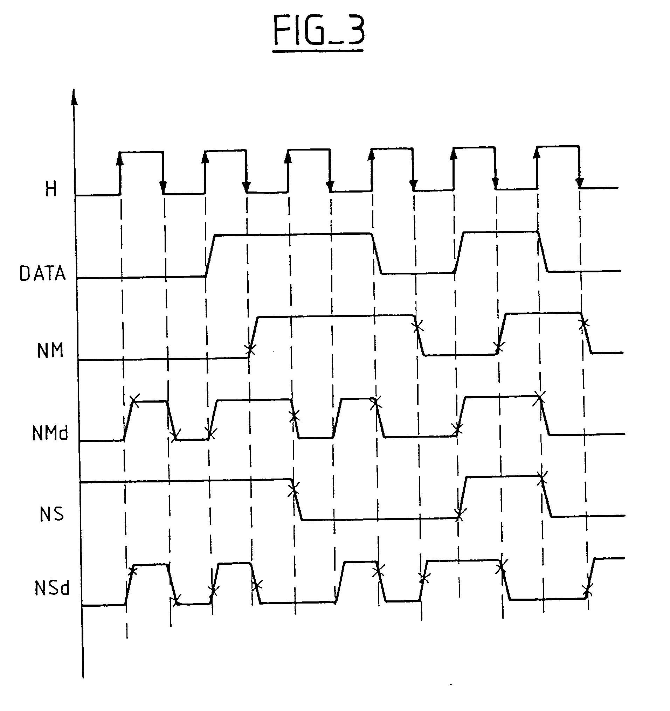

Ceci va être illustré en référence à la figure 3, qui représente les différents états des noeuds internes d'entrée des quatre boucles de mémorisation d'une bascule sécurisée selon l'invention, pour un flot de données DATA présenté en entrée de la bascule D maître-esclave sécurisée selon l'invention.

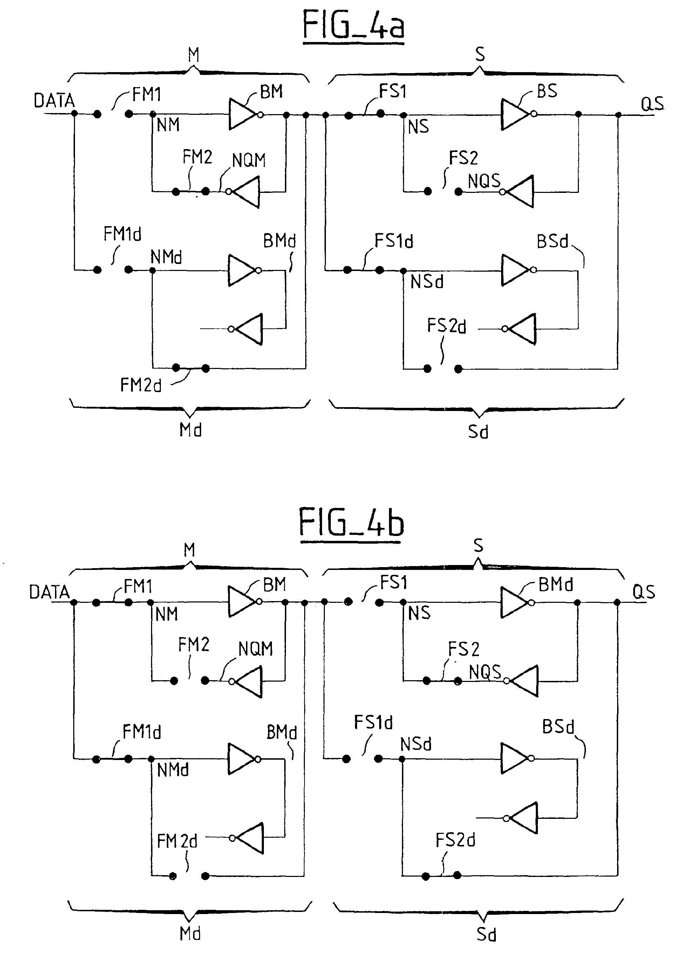

Pour faciliter la compréhension, on a représenté sur les figures 4a et 4b la structure de la bascule selon l'invention avec le schéma équivalent des portes de transfert sur le niveau haut, respectivement sur le niveau bas, du signal d'horloge H.

Un front montant du signal d'horloge H fait passer la bascule dans l'état suivant, représenté sur la figure 4a : les portes FM1, FM1d, FS2, FS2d sont passantes; les portes FM2, FM2d, FS1, FS1d, sont bloquées.

Un front montant du signal d'horloge H fait passer la bascule dans l'état suivant, représenté sur la figure 4b : les portes FM1, FM1d, FS2, FS2d sont bloquées ; les portes FM2, FM2d, FS1, FS1d, sont passantes.

Dans l'exemple de séquence de fonctionnement représentée sur la figure 3, on part des conditions suivantes: niveau bas "0" du signal d'horloge H, noeud interne NM de l'étage maître à "0", noeud interne NMd de l'étage témoin associé à "0", noeud interne NS de l'étage esclave à "1", noeud interne NSd de l'étage témoin associé à "0".

Sur le premier front montant du signal d'horloge H, (Fig. 4a) le noeud NM isolé de l'entrée DATA reste inchangé, à "0". Il n'y donc pas de commutation dans la boucle de mémorisation de l'étage maître. La sortie QM de l'étage maître est à "1". Comme le noeud interne NS de l'étage esclave est déjà à "1", il n'y a pas de changement en entrée de la boucle de mémorisation de l'étage esclave, et donc, pas de commutation dans cette boucle.

Par contre, la porte FM2d de l'étage témoin associé à l'étage maître fait passer le noeud interne NMd de "0" à "1", ce qui entraîne une commutation dans la boucle de mémorisation associée.

La porte FS1d de l'étage témoin de l'étage esclave fait passer le noeud interne NSd associé de "0" à "1", ce qui entraîne une commutation dans la boucle de mémorisation associée.

Ainsi, sur ce premier front montant, on a une commutation dans chacun des étages témoins de la bascule.

Sur le front descendant suivant (Fig.4b), DATA est toujours à "0". Le noeud interne NM de l'étage maître reste à "0". Il n' y donc pas de commutation dans la boucle de mémorisation de l'étage maître.

Par contre, la porte FM1d fait passer le noeud interne NMd de "1" à "0", entraînant une commutation dans la boucle de mémorisation de l'étage témoin associé.

Le noeud interne NS de l'étage esclave reste inchangé, à "1".

La porte FS2d de l'étage esclave fait passer le noeud interne NSd de l'étage témoin esclave de "1" à "0", entraînant une commutation dans la boucle de mémorisation de cet étage témoin.

Ainsi, sur ce front descendant, on a une commutation dans chacun des étages témoins de la bascule.

Sur le front montant suivant, la donnée DATA est passée à "1". Le noeud NM isolé de l'entrée DATA reste inchangé, à "0". Il n' y donc pas de commutation dans la boucle de mémorisation de l'étage maître.

La sortie QM de l'étage maître est à "1". La porte FM1d fait donc passer le noeud interne NMd de "0" à "1", entraînant une commutation dans la boucle de mémorisation de l'étage témoin associé.

Le noeud interne NS de l'étage esclave reste inchangé, puisqu'il est déjà à "1". Il n'y a donc pas de commutation dans la boucle de mémorisation de l'étage esclave.

La porte FS1d de l'étage témoin esclave fait passer le noeud interne NSd de "0" à "1", ce qui entraîne une commutation dans la boucle de mémorisation associée.

Ainsi, sur ce front montant, on a une commutation dans chacun des étages témoins de la bascule.

Sur le front descendant suivant, DATA est toujours à "1". Le noeud interne NM de l'étage maître passe de "0" à "1", ce qui entraîne une commutation dans la boucle de mémorisation de l'étage maître.

Le noeud interne NMd reste à "1". Il n'y a donc pas de commutation dans la boucle de mémorisation de l'étage témoin associé à l'étage maître.

Le noeud interne NS de l'étage esclave reste inchangé, à "1".

La porte FS2d de l'étage esclave fait passer le noeud interne NSd de l'étage témoin associé de "1" à "0", entraînant une commutation dans la boucle de mémorisation de cet étage témoin.

Ainsi, sur ce front descendant, on a une commutation dans l'étage maître et dans l'étage témoin associé à l'étage esclave.

On peut ainsi montrer que quelles que soient les conditions dans la bascule et quel que soit le flot de données en entrée, on aura toujours une commutation de deux des boucles de la bascule D maître-esclave sécurisée selon l'invention. Sur la figure 3, on a indiqué d'une croix les commutations qui sont réalisées à chaque front du signal d'horloge. La commutation d'une boucle doit bien sûr se comprendre comme la commutation de chacun des inverseurs de la boucle. Dans les étages témoins, si la boucle de mémorisation est réalisée par une capacité équivalente, cela se traduit par la commutation de cette capacité, ou plus exactement par sa charge ou sa décharge.

En utilisant une telle bascule D maître-esclave sécurisée pour chaque cellule des registres amenés à traiter des données confidentielles dans un circuit électronique, on empêche ainsi de mener des attaques DPA pendant les temps d'utilisation de ces registres.

On notera qu'en pratique, lorsque ces registres ne sont pas utilisés, ils ne sont le siège d'aucune commutation (le signal d'horloge n'est pas transmis).

Une bascule D maître-esclave sécurisée selon l'invention peut-être utilisée dans toutes les applications dans lesquelles il est utile d'empêcher toute analyse différentielle de la consommation en courant.

L'invention ne se limite pas à la structure de la bascule plus particulièrement décrite. En particulier le terme inverseur est à prendre dans son sens le plus général, fonctionnel, indépendamment de sa constitution.

## Revendications

1. Bascule de type D maître-esclave, comprenant un étage maître suivi d'un étage esclave, les deux étages étant de structure identique comprenant une première porte de transfert (FM1) pour transmettre sur un noeud interne (NM) une donnée d'entrée (DATA), une boucle de mémorisation à inverseurs (BM) connectée au dit noeud interne (NM) pour fournir une donnée en sortie (QM) de l'étage et comprenant une deuxième porte de transfert (FM2) pour transmettre sur le dit noeud interne (NM) la donnée complémentaire (NQM) de la donnée de sortie, **caractérisée en ce que** la bascule comprend en outre un circuit de masquage de consommation comprenant en parallèle sur chacun des étages maître et esclave, un étage témoin (Md) de structure similaire dont la boucle de mémorisation (BMd) est déconnectée de la sortie (QM) de l'étage maître ou esclave associé, la deuxième porte de transfert de cette boucle de mémorisation de l'étage témoin étant connectée entre la sortie (QM) de l'étage maître ou esclave associé et le noeud interne (NMd) de l'étage témoin.

2. Bascule de type D maître-esclave selon la revendication 1, **caractérisée en ce que** la boucle de mémorisation dans chacun des étages témoins est réalisée par une charge équivalente vue du noeud interne de l'étage, à la chaîne d'inverseurs de la boucle de mémorisation de l'étage maître ou esclave.

3. Circuit intégré comprenant une ou plusieurs bascules D maître-esclave selon la revendication 1 ou 2.

4. Circuit intégré selon la revendication 3, **caractérisé en ce que** les dites bascules forment des registres pour traiter des données confidentielles.

5. Carte à puce ou microcircuit comprenant un circuit intégré selon la revendication 3 ou 4.

6. Système électronique utilisant une carte à puce ou un microcircuit selon la revendication 5.

## Claims

1. A master-slave D type flip-flop comprising a master stage followed by a slave stage, the two stages having an identical structure comprising a first pass gate (FM1) for the transmission on an internal node (NM) of an input data element (DATA), a storage loop (BM) with inverters connected to said internal node (NM) to supply a data element at output (QM) of the stage and comprising a second pass gate (FM2) for the transmission on said internal node (NM) of the data element (NQM) complementary to the output data element, **characterized in that** the flip-flop further comprises a power consumption masking circuit comprising in parallel at each of the master and the slave stages, a reference stage (Md) with a similar structure whose storage loop (BMd) is disconnected from the output (QM) of the associated master or slave stage, the second pass gate of said storage loop of the reference stage being connected between the output (QM) of the associated master or slave stage and the internal node NMd) of the reference stage.

2. A master-slave D type flip-flop according to claim 1, **characterized in that** the storage loop in each of the reference stages is formed by a load that is equivalent when seen from the internal node of the stage to the chain of inverters of the storage loop of the master or slave stage.

3. An integrated circuit comprising one or several master-slave D flip-flops according to claim 1 or 2.

4. An integrated circuit according to claim 3, **characterized in that** said flip-flops form registers to process confidential data.

5. A smart card or microcircuit comprising an integrated circuit according to claim 3 or 4.

6. An electronic system using a smart card or a microcircuit according to claim 5.

## Patentansprüche

1. Typ D Master-Slave Kippschaltung mit einer Master-Stufe, der eine Slave-Stufe nachfolgt, wobei die beiden Stufen eine identische Struktur haben, mit einem ersten Transfer-Gate (FM1), um über einen internen Knoten (NM) ein Eingangsdatum (DATA) zu übertragen, einer Inverter-Speicherschaltung (BM), die an den internen Knoten (NM) angeschlossen ist, um ein Ausgangsdatum (QM) der Stufe zu liefern, und mit einem zweiten Transfer-Gate (FM2), um über den internen Knoten (NM) das komplementäre Datum (NQM) des Ausgangsdatums zu übertragen, **dadurch gekennzeichnet, dass** die Kippschaltung ferner eine Verbrauchs-Maskierungsschaltung umfasst, mit in Parallelanordnung auf jeder der Master-Slave-Stufen einer Teststufe (Md) mit ähnlicher Struktur, deren Speicherschleife (BMd) vom Ausgang (QM) der verbundenen Master- oder Slave-Stufe getrennt ist, wobei das zweite Transfer-Gate dieser Speicherschleife der Teststufe zwischen dem Ausgang (QM) der verbundenen Master- oder Slave-Stufe und dem internen Knoten (NMd) der Teststufe angeschlossen ist.

2. Typ D Master-Slave Kippschaltung nach Anspruch 1, **dadurch gekennzeichnet, dass** die Speicherschleife in jeder der Teststufen durch eine vom internen Knoten der Stufe ausgesehen äquivalente Ladung an der Inverterkette der Speicherschleife der Master- oder Slave-Stufe realisiert ist.

3. Integrierter Schaltkreis mit ein oder mehreren Typ D Master-Slave-Kippschaltungen nach Anspruch 1 oder 2.

4. Integrierter Schaltkreis nach Anspruch 3, **dadurch gekennzeichnet, dass** die Kippschaltungen Register bilden, um vertrauliche Daten zu behandeln.

5. Chipkarte oder Mikroschaltung mit einem integrierten Schaltkreis nach Anspruch 3 oder 4.

6. Elektronisches System, das eine Chipkarte oder eine Mikroschaltung nach Anspruch 5 verwendet.
